# DEMANDE DE BREVET EUROPEEN

(11) **EP 4 776 513 A1**
(43) Date de publication de la demande: **15.07.2026**
(21) Numéro de dépôt: 25227287.7
(22) Date de dépôt: 26.12.2025
(51) Int. Cl.: H03K 17/13, H03K 17/567, H03K 17/723, H03K 17/725

(54) **DISPOSITIF DE COMMANDE DE COMMUTATEUR DE PUISSANCE A TROIS ELECTRODES**

(30) Priorité: 09.01.2025 FR 2500185
(71) Demandeur: STMicroelectronics International N.V., 1228 Plan-les-Ouates, Geneva (CH)
(72) Inventeur: BENABDELAZIZ, Ghafour, 37100 TOURS (FR)
(74) Mandataire: Cabinet Beaumont

(57) **Abrégé**

La présente description concerne un dispositif de commande (100) d'un commutateur de puissance (200) à trois électrodes (202, 204, 206), comprenant :
- un circuit de détection (102) comprenant des transistors bipolaires (108, 110, 110) couplés à une première électrode de puissance (202) du commutateur de puissance, et configuré pour extraire un courant de détection dont la valeur est proportionnelle à celle d'une tension entre la première et une deuxième électrodes de puissance (202, 204) du commutateur de puissance lorsque le commutateur de puissance est bloqué ;
- un circuit d'amorçage (104), couplé à une électrode de commande (206) du commutateur de puissance et au circuit de détection, et configuré pour délivrer un courant d'amorçage non nul sur l'électrode de commande lorsque le courant de détection est nul et qu'un signal de commande d'amorçage non nul est reçu sur une entrée de commande (106) du circuit d'amorçage.

## Description

### Domaine technique

La présente description concerne de façon générale le domaine de la commande de commutateur, ou interrupteur, de puissance à trois électrodes, en particulier la commande de TRIAC (« Triode for Alternating Current » en anglais, ou triode pour courant alternatif) ou de thyristor, ou SCR (« Silicon Controlled Rectifier » en anglais).

### Technique antérieure

La commande d'un commutateur de puissance à trois électrodes tel qu'un TRIAC ou un thyristor peut nécessiter la présence d'une isolation électrique entre le circuit de commande et le commutateur de puissance, par exemple pour former une isolation de sécurité destinée à séparer la basse tension de la haute tension, ou dans la cas d'une référence de commande du circuit de commande qui n'est pas identique à celle du commutateur de puissance.

De plus, il peut être judicieux de commander l'amorçage du commutateur de puissance lorsque la valeur de la tension alternative appliquée à ses bornes est nulle afin de réduire les courants d'appel pouvant circuler dans le commutateur de puissance ainsi que les contraintes qui en découlent, et éviter un potentiel endommagement des éléments couplés au commutateur de puissance (batterie, chargeur, contrôle d'éclairage, charge résistive, etc.). Une telle commande d'amorçage à une valeur de tension nulle est appelée ZVS (« Zero Voltage Switching » en anglais).

Une première configuration pour réaliser une telle commande ZVS d'un commutateur de puissance consiste à utiliser un opto-TRIAC avec ZVS intégré, couplé entre l'une des électrodes de puissance et l'électrode de commande (la gâchette dans le cas d'un TRIAC ou d'un thyristor) du commutateur de puissance à commander. Un signal de commande d'amorçage du commutateur de puissance est envoyé à l'opto-TRIAC par un circuit de commande correspondant par exemple à un microcontrôleur. Dans cette première configuration, l'isolation électrique entre la partie commande et la partie puissance est assurée par l'opto-TRIAC.

Cette première configuration permet une détection automatique du passage par une valeur nulle de la tension alternative aux bornes du commutateur de puissance pour déclencher son amorçage du fait qu'à la réception du signal de commande d'amorçage, l'opto-TRIAC avec ZVS intégré ne peut déclencher l'amorçage du commutateur de puissance qu'au moment d'un passage par une valeur nulle de la tension alternative aux bornes du commutateur de puissance. Cette première configuration a toutefois pour inconvénient qu'un délai important est présent entre le moment où le signal de commande d'amorçage est envoyé à l'opto-TRIAC et le moment où le commutateur de puissance s'amorce et devient passant, ce qui engendre des perturbations électromagnétiques dans le circuit de puissance comprenant le commutateur de puissance. De plus, lorsque le commutateur de puissance est un TRIAC, cette solution n'est utilisable que pour un amorçage réalisé dans les quadrants Q1 et Q3 (Q1 : tension positive aux bornes du TRIAC et courant de gâchette positif ; Q3 : tension négative aux bornes du TRIAC et courant de gâchette négatif).

Une deuxième configuration pour réaliser une telle commande ZVS du commutateur de puissance consiste à utiliser un opto-transistor couplé en parallèle du commutateur de puissance à commander, un transformateur d'impulsions (« Pulse Transformer » en anglais) couplé à l'électrode de commande du commutateur de puissance et un circuit de commande correspondant par exemple à un microcontrôleur. Dans cette deuxième configuration, l'isolation électrique entre la partie commande et la partie puissance est assurée par le transformateur d'impulsions. Lorsque la tension alternative aux bornes du commutateur de puissance passe par une valeur nulle, celle-ci est détectée par l'opto-transistor qui envoie alors un signal au microcontrôleur l'informant de ce passage par une valeur nulle. Un signal de commande d'amorçage du commutateur de puissance est alors envoyé depuis le microcontrôleur sur la gâchette du commutateur de puissance par l'intermédiaire du transformateur d'impulsions.

Contrairement à la première configuration faisant appel à un opto-TRIAC pour réaliser une commande ZVS automatique, la synchronisation entre l'amorçage du commutateur de puissance et le passage par une valeur nulle de la tension alternative à ses bornes est gérée, dans la deuxième configuration, par le microcontrôleur, et n'est donc pas automatique. En outre, le circuit comprenant l'opto-transistor forme un circuit externe supplémentaire à connecter au circuit de puissance auquel appartient le commutateur de puissance.

### Résumé de l'invention

Il existe un besoin de proposer un dispositif de commande d'au moins un commutateur de puissance à trois électrodes, par exemple un TRIAC ou un thyristor, ne présentant pas au moins une partie des inconvénients des solutions existantes.

Un mode de réalisation pallie tout ou partie des inconvénients des solutions connues et propose un dispositif de commande d'au moins un commutateur de puissance à trois électrodes, comprenant au moins :
- un circuit de détection comprenant des transistors bipolaires couplés à une première électrode de puissance du commutateur de puissance, et configuré pour extraire un courant de détection dont la valeur est proportionnelle à celle d'une tension entre la première et une deuxième électrodes de puissance du commutateur de puissance lorsque le commutateur de puissance est bloqué ;
- un circuit d'amorçage, couplé à une électrode de commande du commutateur de puissance et au circuit de détection, et configuré pour délivrer un courant d'amorçage non nul sur l'électrode de commande lorsque le courant de détection est nul et qu'un signal de commande d'amorçage non nul est reçu sur une entrée de commande du circuit d'amorçage.

Selon un mode de réalisation particulier, le circuit de détection est configuré pour faire passer le courant de détection depuis l'une vers l'autre des première et deuxième électrodes de puissance du commutateur de puissance lorsque le commutateur de puissance est dans un état bloqué.

Selon un mode de réalisation particulier, le dispositif de commande est configuré pour commander le commutateur de puissance qui correspond à un TRIAC, l'électrode de commande correspondant à la gâchette du TRIAC et les électrodes de puissance correspondant aux anodes du TRIAC.

Selon un mode de réalisation particulier, les transistors bipolaires du circuit de détection correspondent au moins à :
- un premier transistor bipolaire de type NPN comprenant sa base couplée à la première électrode de puissance du commutateur de puissance, son collecteur couplé à l'entrée de commande du circuit d'amorçage, et son émetteur couplé à la deuxième électrode de puissance du commutateur de puissance ;
- un deuxième transistor bipolaire de type NPN comprenant sa base couplée à l'émetteur du premier transistor bipolaire, et son émetteur couplé à la base du premier transistor bipolaire ;
- un troisième transistor bipolaire de type PNP comprenant sa base couplée au collecteur du deuxième transistor bipolaire, son émetteur couplé au collecteur du premier transistor bipolaire, et son collecteur couplé à la deuxième électrode de puissance du commutateur de puissance.

Selon un mode de réalisation particulier, le circuit d'amorçage comporte un quatrième transistor bipolaire de type NPN comprenant sa base couplée au collecteur du premier transistor bipolaire, son collecteur couplé à l'entrée de commande du circuit d'amorçage, et son émetteur couplé à l'électrode de commande du commutateur de puissance, ou un transistor MOSFET comprenant sa grille couplée au collecteur du premier transistor bipolaire, une première électrode de source ou de drain couplée à l'entrée de commande du circuit d'amorçage, et une deuxième électrode de source ou de drain couplée à l'électrode de commande du commutateur de puissance.

Selon un mode de réalisation particulier, les transistors bipolaires du circuit de détection correspondent au moins à :
- un premier transistor bipolaire de type PNP comprenant sa base couplée à une première des deux électrodes de puissance du commutateur de puissance, son émetteur couplé à une deuxième des deux électrodes de puissance du commutateur de puissance, et son collecteur couplé à l'entrée de commande du circuit d'amorçage, et
- un deuxième transistor bipolaire de type NPN comprenant sa base couplée à la base du premier transistor bipolaire, son émetteur couplé au collecteur du premier transistor bipolaire, et son collecteur couplé à l'émetteur du premier transistor bipolaire.

Selon un mode de réalisation particulier, le circuit d'amorçage comporte un troisième transistor bipolaire comprenant sa base couplée à l'émetteur du premier transistor bipolaire et au collecteur du deuxième transistor bipolaire, son émetteur couplé au collecteur du premier transistor bipolaire, et son collecteur couplé à l'électrode de commande du commutateur de puissance, ou un transistor MOSFET comprenant sa grille couplée à l'émetteur du premier transistor bipolaire et au collecteur du deuxième transistor bipolaire, une première électrode de source ou de drain couplée au collecteur du premier transistor bipolaire, et une deuxième électrode de source ou de drain couplée à l'électrode de commande du commutateur de puissance.

Selon un mode de réalisation particulier, le dispositif de commande comporte en outre au moins une première résistance électrique de limitation de courant couplée entre la première des deux électrodes de puissance du commutateur de puissance et le circuit de détection.

Selon un mode de réalisation particulier, le dispositif de commande comporte en outre une capacité électrique couplée entre l'entrée de commande du circuit d'amorçage et la deuxième électrode de puissance du commutateur de puissance.

Selon un mode de réalisation particulier, le dispositif de commande comporte en outre un circuit de connexion configuré pour connecter ou non le circuit de détection à la première électrode de puissance du commutateur de puissance.

Selon un mode de réalisation particulier, le dispositif de commande comporte en outre au moins une deuxième résistance électrique de limitation de courant couplée à l'électrode de commande du commutateur de puissance.

Selon un mode de réalisation particulier, le dispositif de commande comporte en outre un circuit d'attaque doté d'au moins une sortie couplée à l'entrée de commande du circuit d'amorçage et comprenant une isolation galvanique.

Selon un mode de réalisation particulier, le circuit d'attaque comporte un microcontrôleur.

Selon un mode de réalisation particulier, le circuit d'attaque est configuré pour envoyer sur sa sortie le signal de commande d'amorçage sous la forme d'impulsions synchronisées avec des passages par une valeur nulle d'une tension aux bornes des électrodes de puissance du commutateur de puissance.

Il est également proposé un système de puissance comprenant au moins le commutateur de puissance et un dispositif de commande couplé aux deux électrodes de puissance et à l'électrode de commande du commutateur de puissance.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
- la figure 1 représente un exemple de dispositif de commande d'au moins un commutateur de puissance à trois électrodes selon un premier mode de réalisation ;
- la figure 2, la figure 3, la figure 4, la figure 5 et la figure 6 représentent des exemples de signaux obtenus en utilisant le dispositif de commande de la figure 1 ;
- la figure 7 représente le bruit électromagnétique obtenu en utilisant le dispositif de commande de la figure 1 ;
- les figures 8 et 9 représentent respectivement des exemples de première et deuxième variantes du dispositif de commande selon le premier mode de réalisation ;
- la figure 10 représente un exemple de dispositif de commande d'au moins un commutateur de puissance à trois électrodes selon un deuxième mode de réalisation ;
- la figure 11 représente des exemples de signaux obtenus en utilisant le dispositif de commande de la figure 10 ;
- la figure 12 et la figure 13 représentent des exemples de signaux obtenus en utilisant un dispositif de commande selon d'autres variantes de réalisation ;
- la figure 14 représente un exemple d'intégration du dispositif de commande selon le deuxième mode de réalisation ;
- la figure 15 représente un exemple d'une autre variante du dispositif de commande d'au moins un commutateur de puissance à trois électrodes selon le premier mode de réalisation ;
- la figure 16 représente un exemple d'une autre variante du dispositif de commande d'au moins un commutateur de puissance à trois électrodes selon le deuxième mode de réalisation ;
- la figure 17 représente des exemples de signaux obtenus en utilisant le dispositif de commande de la figure 15 ;
- la figure 18 représente un exemple d'une autre variante du dispositif de commande d'au moins un commutateur de puissance à trois électrodes selon le premier mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, différents éléments (transistors, transformateur d'impulsions, microcontrôleur, etc.) ne sont pas détaillés. L'homme du métier sera à même de réaliser de manière détaillée ces éléments à partir de la description fonctionnelle de ces éléments fournie ci-dessous.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés (en anglais "coupled") entre eux, cela signifie que ces deux éléments peuvent être connectés ou être reliés par l'intermédiaire d'un ou plusieurs autres éléments. En outre, sauf indication contraire, les termes « couplé », « relié » et « connecté » sont utilisés ici pour désigner des couplages, ou des liaisons, ou des connexions, électriques.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures dans une position normale d'utilisation.

Sauf précision contraire, les expressions "environ", "approximativement", "sensiblement", et "de l'ordre de" signifient à 10 % près, de préférence à 5 % près.

Sans indication contraire, les gammes de valeurs indiquées ici incluent les bornes de ces gammes.

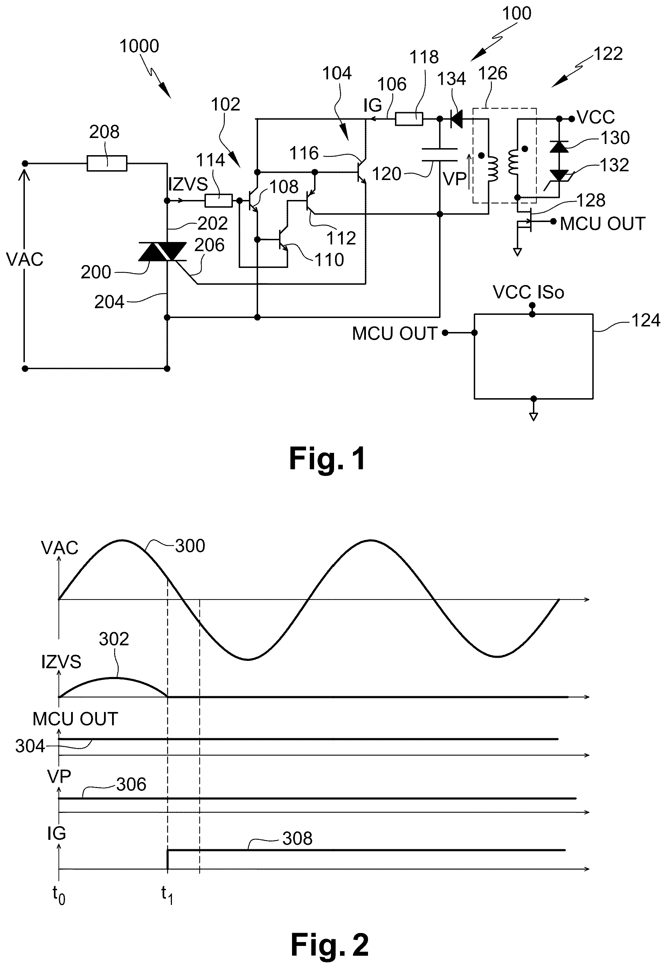

Un exemple d'un dispositif 100 de commande d'un commutateur de puissance à trois électrodes 200 selon un premier mode de réalisation est décrit ci-dessous en lien avec la figure 1.

Le commutateur de puissance 200 comprend deux électrodes de puissance 202, 204 et une électrode de commande 206. Dans l'exemple de réalisation décrit, le commutateur de puissance 200 correspond à un TRIAC dont l'électrode de puissance 202 correspond à l'anode du TRIAC, l'électrode de puissance 204 correspond à la cathode du TRIAC, et dont l'électrode de commande 206 correspond à la gâchette du TRIAC. Par exemple, le dispositif 100 peut être configuré pour commander simultanément un ou plusieurs TRIACs et/ou un ou plusieurs thyristors (dont les électrodes de puissance correspondent à l'anode et à la cathode du thyristor, et dont l'électrode de commande correspond à la gâchette du thyristor) .

Sur l'exemple de la figure 1, le TRIAC 200 est couplé en série avec une charge résistive 208 représentée, sur la figure 1, sous la forme d'une résistance électrique. Une tension alternative VAC est destinée à être appliquée aux bornes de l'ensemble comprenant le TRIAC 200 et la charge résistive 208, c'est-à-dire entre l'électrode de la charge résistive 208 qui n'est pas couplée au TRIAC 200 et la cathode 204 du TRIAC 200 (l'anode 202 du TRIAC 200 étant couplée à la charge résistive 208). En variante, un ou plusieurs autres composants électriques et/ou électroniques du circuit de puissance auquel appartient le TRIAC 200 peuvent être couplés au TRIAC 200. A titre d'exemple, la valeur de la tension VAC peut être égale à 240 V_{RMS}, ou plus généralement comprise entre 85 V_{RMS} et 264 V_{RMS} dans le cas d'un réseau monophasé, ou entre 85 V_{RMS} et 460 V_{RMS} dans le cas d'un réseau triphasé, en fonction de l'application envisagée.

Le dispositif 100 comporte un circuit de détection 102 comprenant des transistors bipolaires couplés à l'une des deux électrodes de puissance 202, 204 du TRIAC 200 et configuré pour extraire un courant de détection (courant appelé *IZVS* sur la figure 1) dont la valeur est proportionnelle notamment à celle d'une tension entre les deux électrodes 202, 204 lorsque le TRIAC 200 est bloqué. Dans l'exemple de réalisation décrit, le circuit de détection 102 extrait le courant de détection *IZVS* depuis l'anode 202 du TRIAC 200.

Le dispositif 100 comporte également un circuit d'amorçage 104 du TRIAC 200, couplé à la gâchette 206 du TRIAC 200 et au circuit de détection 102, et configuré pour délivrer un courant d'amorçage non nul sur la gâchette 206 lorsque le courant de détection est nul et qu'un signal de commande d'amorçage non nul est reçu sur une entrée de commande 106 du circuit d'amorçage 104.

Dans l'exemple de réalisation décrit, le circuit de détection 102 est configuré pour faire passer le courant de détection *IZVS* de l'une à l'autre des électrodes 202, 204 du TRIAC 200 lorsque le TRIAC 200 est dans un état bloqué.

Dans l'exemple de réalisation décrit, le circuit de détection 102 comporte au moins :
- un premier transistor bipolaire 108 de type NPN comprenant sa base couplée à l'anode 202 du TRIAC 200, son collecteur couplé à l'entrée de commande 106 du circuit d'amorçage 104, et son émetteur couplé à la cathode 204 du TRIAC 200 ;
- un deuxième transistor bipolaire 110 de type NPN comprenant sa base couplée à l'émetteur du premier transistor bipolaire 108, et son émetteur couplé à la base du premier transistor bipolaire 108 ;
- un troisième transistor bipolaire 112 de type PNP comprenant sa base couplée au collecteur du deuxième transistor bipolaire 110, son émetteur couplé au collecteur du premier transistor bipolaire 108, et son collecteur couplé à la cathode 204 du TRIAC 200.

Dans l'exemple de réalisation décrit, le dispositif 100 comporte en outre au moins une première résistance électrique de limitation de courant 114 couplée entre l'anode 202 du TRIAC 200 et le circuit de détection 102. Plus particulièrement, sur l'exemple de la figure 1, la première résistance 114 est couplée entre l'anode 202 du TRIAC 200 et la base du premier transistor bipolaire 108, et également entre l'anode du TRIAC 200 et l'émetteur du deuxième transistor bipolaire 110. Cette première résistance 114 permet de limiter le courant de détection *IZVS* envoyé dans les premier et deuxième transistors bipolaires 108, 110. La valeur du courant de détection *IZVS* est proportionnelle également à la valeur de la première résistance 114. La valeur de la première résistance 114 est par exemple égale à 500 kOhms, ou plus généralement comprise entre 250 kOhms et 2 MOhms, en fonction de l'application envisagée.

Dans l'exemple de réalisation décrit, le circuit d'amorçage 104 comporte un quatrième transistor bipolaire 116 de type NPN comprenant sa base couplée au collecteur du premier transistor bipolaire 108 (et également à l'émetteur du troisième transistor bipolaire 112), son collecteur couplé à l'entrée de commande 106 (et également au collecteur du premier transistor bipolaire 108, à l'émetteur du troisième transistor bipolaire 112 et à sa propre base), et son émetteur couplé à la gâchette 206 du TRIAC 200.

Dans l'exemple de réalisation décrit, le dispositif 100 comporte en outre au moins une deuxième résistance électrique de limitation de courant 118 couplée à l'entrée de commande 106 afin de limiter le courant dans la gâchette 206 du TRIAC 200. Sur l'exemple de la figure 1, la deuxième résistance 118 comporte une première de ses électrodes couplée au collecteur du premier transistor bipolaire 108, à l'émetteur du troisième transistor bipolaire 112, et au collecteur et à la base du quatrième transistor bipolaire 116. La deuxième résistance 118 permet ici de limiter le courant d'amorçage destiné à être envoyé sur la gâchette 206 du TRIAC 200 à travers le quatrième transistor bipolaire 116. La valeur de la deuxième résistance 118 est par exemple égale à 56 Ohms, ou plus généralement comprise entre 20 Ohms et 15 kOhms, en fonction de l'application envisagée.

Dans l'exemple de réalisation décrit, le dispositif 100 comporte en outre une capacité électrique 120, par exemple formée par un condensateur, couplée entre l'entrée de commande 106 et la cathode 204 du TRIAC 200. Sur l'exemple de la figure 1, la capacité électrique 120 est couplée entre une deuxième électrode de la résistance électrique 118 et le collecteur du troisième transistor bipolaire 112 qui est lui-même couplé à la cathode 204 du TRIAC 200. La valeur de la capacité électrique 120 est par exemple comprise entre 33 nF et 10 µF, en fonction de l'application envisagée.

Dans l'exemple de réalisation décrit, le dispositif 100 comporte en outre un circuit d'attaque 122 (« Driver circuit » en anglais) doté d'au moins une sortie couplée à l'entrée de commande 106 et isolée de manière galvanique vis-à-vis d'autres éléments du circuit d'attaque 122. Selon une réalisation particulière correspondant à celle représentée sur la figure 1, le circuit d'attaque 122 comporte un microcontrôleur 124.

Dans l'exemple de la figure 1, le circuit d'attaque 122 comporte également un transformateur d'impulsions 126 doté d'un primaire couplé à un transistor MOSFET 128 dont la grille est couplée à une sortie du microcontrôleur 124 sur laquelle un signal de commande d'amorçage « MCU OUT » est délivré. Sur l'exemple de la figure 1, le transistor MOSFET 128 est de type N, et comporte son drain couplé à l'une des extrémités de l'enroulement primaire du transformateur d'impulsions 126, et sa source couplée à un potentiel électrique de référence tel que la masse du circuit d'attaque 122. En variante, le transistor 128 peut être un transistor bipolaire. Sur l'exemple de la figure 1, le circuit d'attaque 122 comporte également une diode 130 et une diode Zener 132 formant un ensemble couplé en parallèle au primaire du transformateur d'impulsions 126. Le secondaire du transformateur d'impulsions 126 est couplé en parallèle à la capacité électrique 120 à travers une autre diode 134. A titre d'exemple, la valeur du courant délivré en sortie du circuit d'attaque 122 est par exemple égale à environ 65 mA, ou plus généralement comprise entre 1 mA et 200 mA.

Dans l'exemple décrit, les diodes 130, 132 et 134 permettent de démagnétiser le circuit magnétique du transformateur d'impulsions 126 à chaque ouverture du transistor 128.

Le dispositif 100 selon le premier mode de réalisation permet de commander un amorçage du TRIAC 200 dans les quadrants Q1 et Q4, c'est-à-dire en appliquant un courant d'amorçage positif sur la gâchette 206 du TRIAC 200 et avec une tension aux bornes du TRIAC 200 qui est positive (Q1) ou négative (Q4).

Lorsque le TRIAC 200 est dans un état bloqué, les premier, deuxième et troisième transistors bipolaires 108, 110 et 112 font passer le courant de détection *IZVS* de l'une à l'autre des électrodes 202, 204 du TRIAC 200. La commutation de ces transistors 108, 110 et 112 se produit lors des passages de ce courant par une valeur nulle, ce qui permet de détecter automatiquement quand se produisent ces passages grâce à ces commutations. Or, étant donné que la valeur de ce courant est proportionnelle à la valeur de la tension aux bornes du TRIAC 200 lorsque le TRIAC 200 est bloqué, la commutation des transistors 108, 110, 112 permet de détecter le passage à une valeur nulle de la tension aux bornes du TRIAC 200. Plus particulièrement, lorsque la tension entre les électrodes 202, 204 du TRIAC 200 est positive, le courant de détection *IZVS* passe de l'anode 202 à la cathode 204 du TRIAC 200 à travers le premier transistor bipolaire 108. Lorsque la tension entre les électrodes 202, 204 du TRIAC 200 est négative, le courant de détection *IZVS* passe de la cathode 204 à l'anode 202 du TRIAC 200 à travers le deuxième transistor bipolaire 110. Le troisième transistor bipolaire 112 permet de dévier le courant de base du quatrième transistor bipolaire 116, du fait que le troisième transistor bipolaire 112 est commandé par le deuxième transistor bipolaire 110 et pour éviter d'amorcer le quatrième transistor bipolaire 116 et fournir du courant dans la gâchette 206 du TRIAC 200 lorsque le courant *IZVS* est non nul.

Dans ce premier mode de réalisation, le quatrième transistor bipolaire 116 fonctionne comme un transistor de commande fournissant un courant d'amorçage non nul positif sur la gâchette 206 du TRIAC 200 lorsque le courant de détection *IZVS* est nul et qu'un signal de commande d'amorçage non nul est reçu sur l'entrée de commande 106. Dans l'exemple de la figure 1, le courant d'amorçage est fourni par la capacité électrique 120 qui a été préchargée par le transformateur d'impulsions 126.

La figure 2 représente des exemples de signaux obtenus dans le dispositif 100 selon le premier mode de réalisation et tel que précédemment décrit en lien avec la figure 1 lors d'un amorçage du TRIAC 200. Sur la figure 2, la référence 300 désigne la tension alternative VAC appliquée aux bornes de l'ensemble formé par le TRIAC 200 et la charge résistive 208, la référence 302 désigne le courant de détection *IZVS* extrait par le circuit de détection 102, la référence 304 désigne le signal de commande d'amorçage MCU OUT envoyé par le microcontrôleur 124 sur la grille du transistor MOSFET 128, la référence 306 désigne la tension VP obtenue aux bornes du primaire du transformateur d'impulsions 126, et la référence 308 désigne le courant d'amorçage IG reçu sur la gâchette 206 du TRIAC 200. Dans l'exemple de réalisation décrit, le signal de commande d'amorçage MCU OUT correspond à un courant modulé PWM (« Pulse Width Modulation » en anglais, ou modulation par largeur d'impulsion) dont la valeur continue est par exemple égale à 3,3 V, ou plus généralement comprise entre 3 V et 5 V. De plus, le courant d'amorçage IG envoyé dans la gâchette 206 est par exemple de l'ordre d'une centaine de milliampères, ou plus généralement compris entre 200 µA et 200 mA.

Sur la figure 2, entre les instants t0 et t1, la tension VAC est positive et la valeur du courant de détection *IZVS* varie proportionnellement à celle de la tension VAC. Entre les instants t0 et t1, le premier transistor bipolaire 108 est passant, et les autres transistors bipolaires 110, 112 et 116 sont bloqués. Bien que le signal de commande d'amorçage MCU OUT soit non nul entre ces instants, le courant d'amorçage IG reste nul compte tenu du fait que le quatrième transistor bipolaire 116 est bloqué. A l'instant t1, la tension aux bornes du TRIAC 200 est nulle et le courant de détection *IZVS* est également nul. Le premier transistor bipolaire 108 passe alors à l'état bloqué, les deuxième et troisième transistors bipolaires 110, 112 restant à l'état bloqué. Par contre, le quatrième transistor bipolaire 116 devient passant. Compte tenu du signal de commande d'amorçage MCU OUT non nul envoyé du microcontrôleur 124 au circuit d'attaque 122, la tension VP aux bornes du secondaire du transformateur d'impulsions 126 est non nulle. Le passage à l'état passant du quatrième transistor bipolaire 116 entraîne alors l'envoi d'un courant d'amorçage IG non nul dans la gâchette 206 du TRIAC 200, déclenchant son amorçage. A titre d'exemple, la valeur du courant d'amorçage IG permettant de déclencher l'amorçage du TRIAC 200 peut être égale à environ 29 mA, ou plus généralement compris entre 200 µA et 200 mA selon les caractéristiques du TRIAC 200.

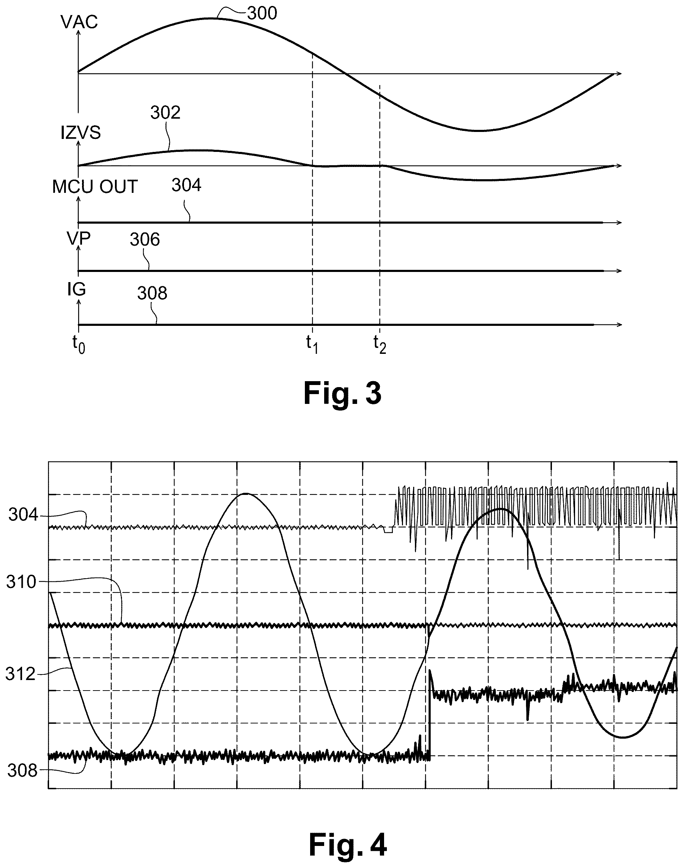

La figure 3 représente des exemples de signaux obtenus dans le dispositif 100 selon le premier mode de réalisation et tel que précédemment décrit en lien avec la figure 1 lors d'un maintien à l'état bloqué du TRIAC 200, lorsque le transistor MOSFET 128 n'est pas commandé.

Sur la figure 3, entre les instants t0 et t1, la tension VAC est positive et la valeur du courant de détection *IZVS* varie proportionnellement à celle de la tension VAC. De plus, entre les instants t0 et t1, le premier transistor bipolaire 108 est passant, et les autres transistors bipolaires 110, 112 et 116 sont bloqués.

Entre les instants t1 et t2, le courant de détection *IZVS* est nul. Le premier transistor bipolaire 108 passe à l'état bloqué et le quatrième transistor bipolaire 116 passe alors à l'état passant. Les deuxième et troisième transistors bipolaires 110, 112 restent à l'état bloqué. Du fait que le signal de commande d'amorçage MCU OUT est nul entre ces instants t1 et t2, le courant d'amorçage *IG* reste nul et le TRIAC 200 reste bloqué.

Après l'instant t2, la tension *VAC* est négative et la valeur du courant de détection *IZVS* varie proportionnellement à celle de la tension VAC. Les deuxième et troisième transistors bipolaires 110, 112 sont passants, et les autres transistors bipolaires 108 et 116 sont bloqués. Le quatrième transistor bipolaire 116 devient passant dès que le premier transistor bipolaire 108 est bloqué (lorsque le tension VAC est positive) ou dès que les deuxième et troisième transistors bipolaires 110, 112 sont bloqués (lorsque la tension *VAC* est négative).

La figure 4 représente des exemples de signaux obtenus dans le dispositif 100 selon le premier mode de réalisation et tel que précédemment décrit en lien avec la figure 1 lors d'un amorçage du TRIAC 200. Sur la figure 4, le courant IAC désigné par la référence 310 correspond au courant traversant le TRIAC 200 et la référence 312 désigne la tension VAK obtenue aux bornes du TRIAC 200. En outre, comme sur les figures 2 et 3, la référence 304 désigne le signal de commande d'amorçage MCU OUT (appelé EN sur la figure 4) envoyé par le microcontrôleur 124 sur la grille du transistor MOSFET 128, et la référence 308 désigne le courant d'amorçage *IG* reçu sur la gâchette 206 du TRIAC 200. Sur cette figure 4, lorsque la valeur du signal MCU OUT n'est plus nulle et telle qu'elle commande l'amorçage du TRIAC 200, ce dernier s'amorce dès que la tension VAK est nulle, ce qui déclenche la mise à l'état passant du quatrième transistor bipolaire 116 et l'envoi du courant d'amorçage IG sur la gâchette 206. Un courant alternatif *IAC* circule alors à travers le TRIAC 200. La tension VAC appliquée aux bornes du TRIAC 200 devient nulle dès que le TRIAC 200 devient passant. Dans ce cas, cette tension est alors appliquée seulement sur la charge 208.

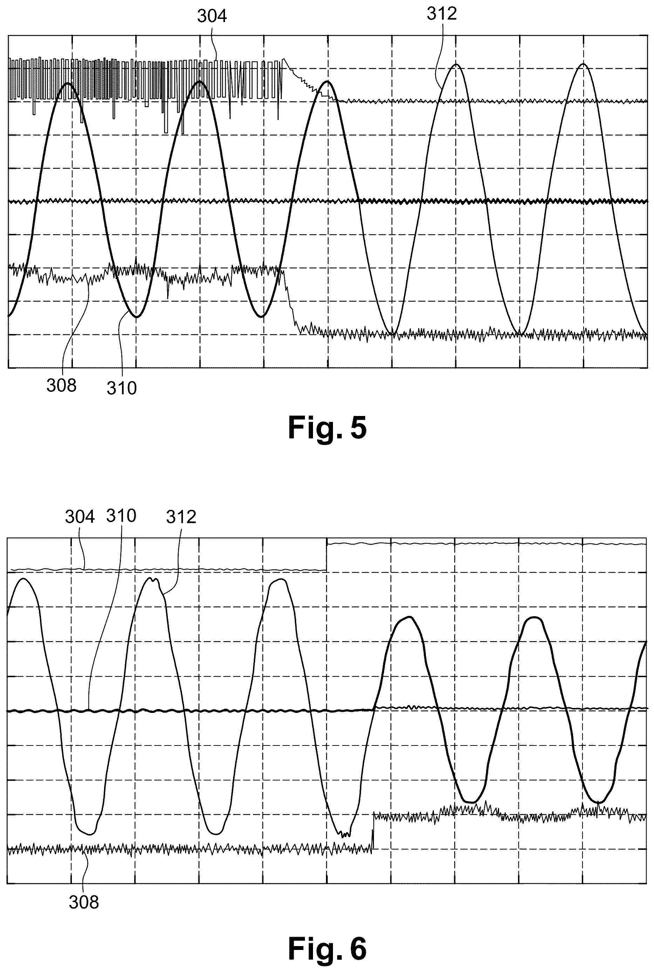

La figure 5 représente des exemples de signaux obtenus dans le dispositif 100 selon le premier mode de réalisation et tel que précédemment décrit en lien avec la figure 1 lors d'un blocage du TRIAC 200. Les signaux représentés sur la figure 5 correspondent à ceux précédemment décrits en lien avec la figure 4. Sur cette figure 5, lorsque le signal de commande d'amorçage MCU OUT devient nul et commande le blocage du TRIAC 200, ce dernier se bloque dès que le courant IAC repasse à une valeur nulle et que le courant IG reçu sur sa gâchette 206 est nul. Dès le blocage du TRIAC 200, la tension *VAK* aux bornes du TRIAC 200 apparaît de nouveau et le courant IAC reste nul.

En variante de l'exemple de réalisation du dispositif 100 précédemment décrit, le circuit d'attaque 122 peut être différent de celui-ci représenté sur la figure 1 et peut correspondre à tout type de circuit d'attaque permettant une commande isolée électriquement d'un ou plusieurs commutateurs de puissance à trois électrodes. La figure 6 représente des exemples de signaux obtenus dans le dispositif 100 selon le premier mode de réalisation et tel que précédemment décrit en lien avec la figure 1 lors d'un amorçage du TRIAC 200, avec toutefois un circuit d'attaque 122 différent de celui précédemment décrit et qui correspond à un convertisseur DC/DC isolé à l'aide d'une isolation de type transformateur.

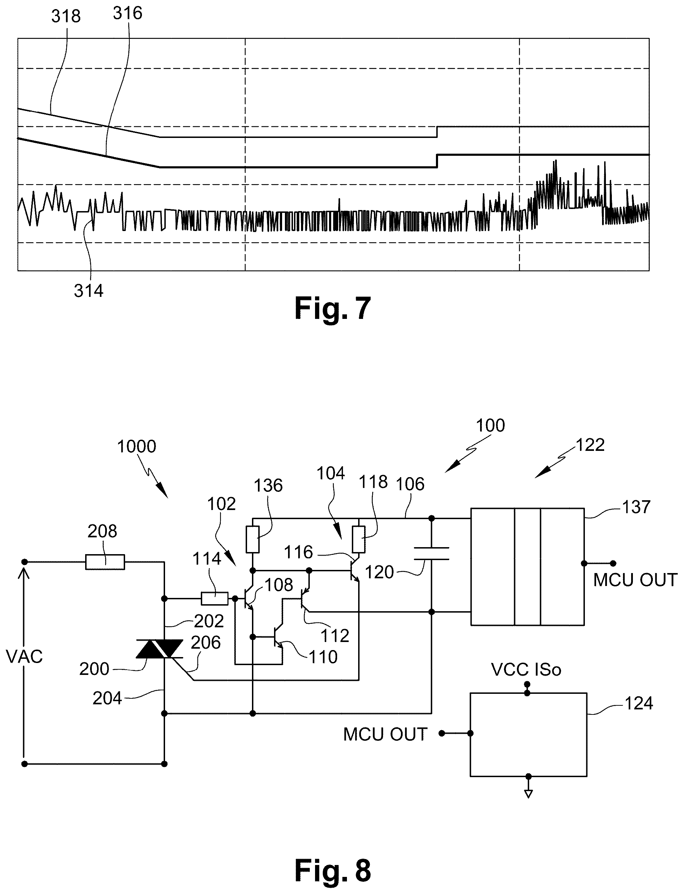

La courbe 314 visible sur la figure 7 représente le bruit électromagnétique du dispositif 100 mesuré à différentes fréquences, et qui correspond à une décomposition en série de Fourier du courant *IAC.* La référence 316 désigne la valeur moyenne maximale admissible selon la norme NF EN IEC 55014-1 et la référence 318 désigne la valeur quasi-crête maximale admissible selon cette norme. La courbe 314 montre que, quelle que soit la valeur de la fréquence considérée, le bruit électromagnétique obtenu dans le dispositif 100 reste conforme aux exigences de la norme NF EN IEC 55014-1.

Dans l'exemple de réalisation précédemment décrit, la deuxième résistance électrique 118 couplée à l'entrée de commande 106 comporte une première de ses électrodes couplée au collecteur du premier transistor bipolaire 108, à l'émetteur du troisième transistor bipolaire 112 et au collecteur du quatrième transistor bipolaire 116, et une deuxième de ses électrodes couplée à l'une des électrodes de la capacité électrique 120.

Dans une première variante de réalisation du dispositif 100 représentée sur la figure 8, la première électrode de la deuxième résistance électrique 118 est couplée au collecteur du quatrième transistor bipolaire 116 et sa deuxième électrode est couplée à l'une des électrodes de la capacité électrique 120. Dans cette première variante, le dispositif 100 comporte en outre une troisième résistance électrique de limitation de courant 136 comprenant une première électrode couplée au collecteur du premier transistor bipolaire 108, à l'émetteur du troisième transistor bipolaire 112 et à la base du quatrième transistor bipolaire 116, et une deuxième électrode couplée à la deuxième électrode de la deuxième résistance électrique 118 et à la capacité électrique 120. Cette troisième résistance électrique 136 permet de limiter le courant envoyé dans les premier et troisième transistors bipolaires 108, 112, et permet de réduire notamment la consommation électrique du dispositif 100 lorsque ces transistors sont à l'état passant. Par exemple, la valeur de la troisième résistance électrique 134 est supérieure ou égale à environ 1 kOhms. En outre, dans cette première variante, l'ensemble formé par les transformateur d'impulsions 126, le transistor MOS 128 et les diodes 130, 132, 134 est remplacé par un unique circuit 137 possédant notamment une isolation galvanique entre une partie réalisant la réception du signal de commande d'amorçage MCU OUT et une autre partie couplée à la capacité électrique 120 et servant à l'envoi du courant d'amorçage IG.

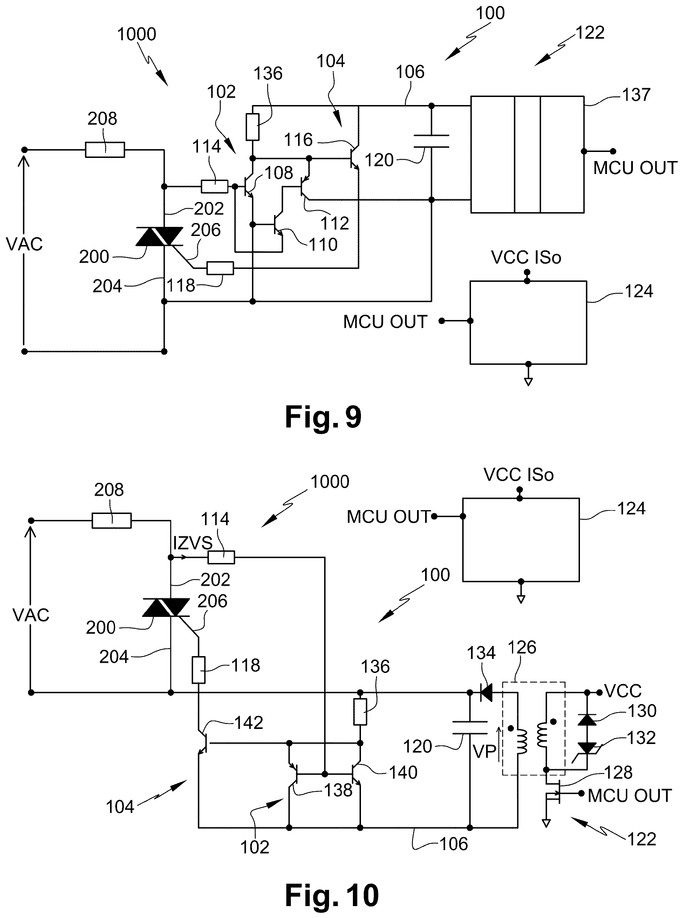

Dans une deuxième variante de réalisation du dispositif 100 représentée sur la figure 9, le dispositif 100 comporte la troisième résistance électrique 136 couplée comme dans la première variante précédemment décrite. Par contre, la deuxième résistance électrique 118 est ici couplée entre la gâchette 206 du TRIAC 200 et l'émetteur du quatrième transistor bipolaire 116.

D'une manière générale, la configuration précédemment décrite en lien avec la figure 1 permet de réduire le nombre de résistances électriques à coupler au dispositif 100. La configuration précédemment décrite en lien avec la figure 3 permet d'intégrer l'ensemble et de mettre une résistance à l'extérieur du dispositif 100 pour régler le courant d'amorçage IG.

Un exemple du dispositif 100 selon un deuxième mode de réalisation est décrit ci-dessous en lien avec la figure 10.

Dans ce deuxième mode de réalisation, le circuit de détection 102 comporte au moins :
- un premier transistor bipolaire 138 de type PNP comprenant sa base couplée à l'anode 202 du TRIAC 200 via la première résistance électrique 114, son émetteur couplé à la cathode 204 du TRIAC 200 via la troisième résistance électrique 136, et son collecteur couplé à l'entrée de commande 106 du circuit d'amorçage 104, et
- un deuxième transistor bipolaire 140 de type NPN comprenant sa base couplée à la base du premier transistor bipolaire 138, son émetteur couplé au collecteur du premier transistor bipolaire 138, et son collecteur couplé à l'émetteur du premier transistor bipolaire 138.

Dans l'exemple de réalisation décrit, le circuit d'amorçage 104 comporte un troisième transistor bipolaire 142 comprenant sa base couplée à l'émetteur du premier transistor bipolaire 138 et au collecteur du deuxième transistor bipolaire 140, son émetteur couplé au collecteur du premier transistor bipolaire 138 et à l'émetteur du deuxième transistor bipolaire 140, et son collecteur couplé à la gâchette 206 du TRIAC 200 via la deuxième résistance électrique 118.

Ce deuxième mode de réalisation du dispositif 100 permet de commander un amorçage du TRIAC 200 dans les quadrants Q2 et Q3, c'est-à-dire en appliquant un courant d'amorçage négatif sur la gâchette 206 du TRIAC 200 et avec une tension aux bornes du TRIAC 200 qui soit positive (Q2) ou négative (Q3).

Lorsque le TRIAC 200 est dans un état bloqué, les premier et deuxième transistors bipolaires 138, 140 font passer le courant de détection *IZVS* de l'une à l'autre des électrodes 202, 204 du TRIAC 200. La commutation de ces transistors 138, 140 se produit lors des passages de ce courant de détection *IZVS* par une valeur nulle, ce qui permet de détecter automatiquement quand se produisent ces passages grâce à la détection de ces commutations. Plus particulièrement, lorsque la tension entre les électrodes 202, 204 du TRIAC 200 est positive, le courant de détection *IZVS* passe de l'anode 202 à la cathode 204 du TRIAC 200 à travers le deuxième transistor bipolaire 140. Lorsque la tension entre les électrodes 202, 204 du TRIAC 200 est négative, le courant de détection *IZVS* issu du neutre de la tension *VAC* passe à travers le premier transistor bipolaire 138.

Le troisième transistor bipolaire 142 fonctionne comme un transistor de commande fournissant un courant d'amorçage non nul négatif issu de la gâchette 206 du TRIAC 200 lorsque le courant de détection *IZVS* est nul, et donc que la tension aux bornes du TRIAC 200 est nulle, et qu'un signal de commande d'amorçage non nul est reçu sur l'entrée de commande 106. Dans l'exemple de la figure 1, le courant d'amorçage est fourni par la capacité électrique 120 préchargée par le transformateur d'impulsions 126 et permet de contrôler le TRIAC 200 dans les quadrants Q2 et Q3.

En variante du deuxième mode de réalisation du dispositif 100 précédemment décrit, le circuit d'attaque 122 peut être différent de celui représenté sur la figure 10 et peut correspondre à tout type de circuit d'attaque permettant une commande isolée électriquement d'un ou plusieurs commutateurs de puissance à trois électrodes.

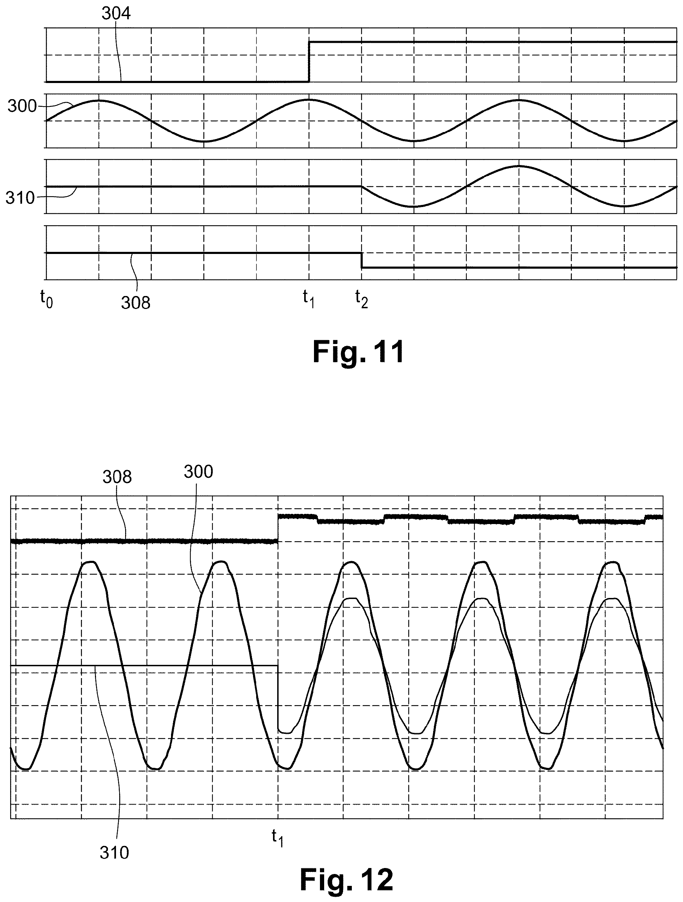

La figure 11 représente des exemples de signaux obtenus dans le dispositif 100 précédemment décrit en lien avec la figure 10 lors d'un amorçage du TRIAC 200. Sur la figure 11, la référence 300 désigne la tension alternative *VAC* appliquée aux bornes de l'ensemble formé par le TRIAC 200 et la charge résistive 208, la référence 304 désigne le signal de commande d'amorçage, appelée *EN,* envoyé par le microcontrôleur 124 pour commander l'amorçage du TRIAC 200, la référence 308 désigne le courant d'amorçage IG reçu sur la gâchette 206 du TRIAC 200, et la référence 310 désigne le courant IAC traversant le TRIAC 200.

Sur la figure 11, entre les instants t0 et t1, la tension alternative VAC passe par des valeurs positives, négatives et nulles. A partir de l'instant t1, le signal *EN* devient non nul et a une valeur commandant l'amorçage du TRIAC 200. A l'instant t2, qui correspond au premier passage par une valeur nulle de la tension VAC depuis l'instant t1, le TRIAC 200 devient passant grâce au courant d'amorçage négatif reçu sur sa gâchette 206. Le courant IAC varie alors proportionnellement à la tension *VAC.*

Dans une variante de réalisation applicable aux premier et deuxième modes de réalisation, le dispositif 100 peut comporter en outre un élément d'interconnexion configuré pour connecter ou non le circuit de détection 102 à la première électrode de puissance du commutateur de puissance, c'est-à-dire à l'anode 202 du TRIAC 200 dans les exemples précédemment décrits. Par exemple, cet élément d'interconnexion peut correspondre à un interrupteur interposé entre la première résistance électrique 114 et l'anode 202 du TRIAC 200. Lorsque le circuit de détection 102 est déconnecté de l'anode 202 du TRIAC 200, l'amorçage du TRIAC 200 se déclenche dès réception du courant d'amorçage non nul sur sa gâchette 206, quelle que soit la valeur de la tension VAC. Dans cette variante, lorsque le circuit de détection 102 est déconnecté du TRIAC 200, l'amorçage du TRIAC 200 peut être déclenché quelle que soit la valeur de la tension VAC.

La figure 12 représente des exemples de signaux obtenus dans un dispositif 100 selon cette variante. Les références utilisées pour désigner les signaux représentés sur cette figure sont similaires à celles utilisées dans les précédentes figures. Sur l'exemple de la figure 12, à l'instant t1, le courant d'amorçage IG non nul est envoyé sur la gâchette 206 du TRIAC 200. Dès cet instant, le TRIAC 200 s'amorce et devient passant quelle que soit la valeur de la tension VAC.

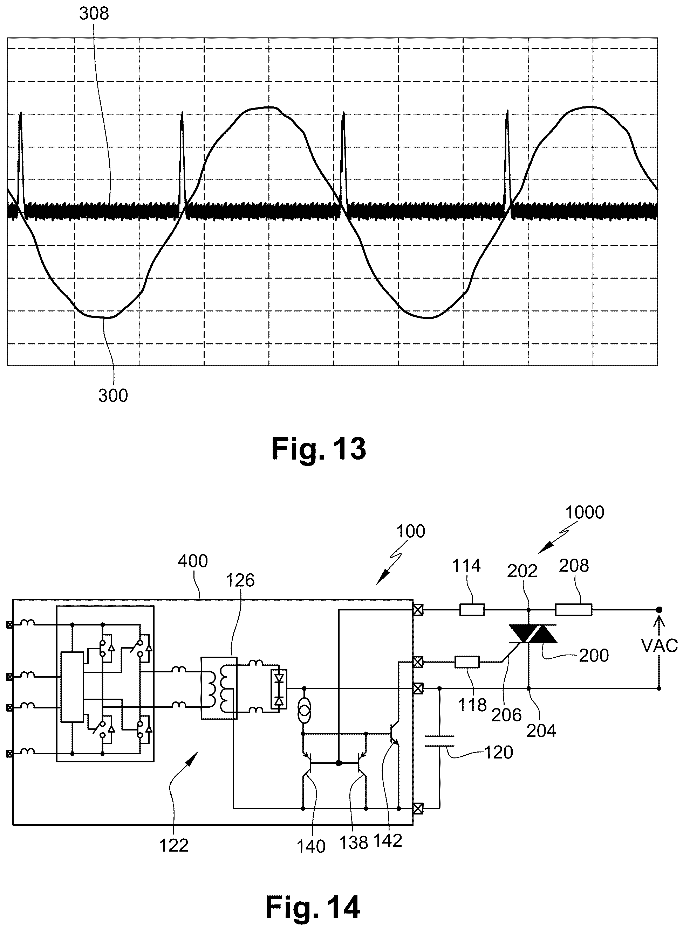

En variante des différents exemples et modes de réalisation précédemment décrits, il est possible que le circuit d'attaque 122 soit configuré pour envoyer sur sa sortie le signal de commande d'amorçage sous la forme d'impulsions synchronisées avec les passages par une valeur nulle de la tension VAC. La figure 13 représente les signaux obtenus dans le dispositif 100 réalisé selon une telle variante. Une telle variante a pour avantage de limiter la consommation électrique du circuit d'attaque 122. Par exemple, dans une telle configuration, l'amplitude de l'impulsion de commande d'amorçage *IG* peut être égale à 1 mA, ou plus généralement comprise entre 100 µA et 200 mA.

La figure 14 représente schématiquement un exemple de réalisation du dispositif 100 réalisé sous la forme d'un circuit intégré 400. Dans cet exemple, le dispositif 100 est réalisé selon le deuxième mode de réalisation. Différents composants de commande du circuit intégré 400 servant à la génération du signal de commande d'amorçage sont représentés sur la figure 14 mais ne sont pas décrits en détail ici. Les première et deuxième résistances 114, 118 et la capacité électrique 120 ne sont pas intégrées au circuit intégré 400 mais correspondent à des composants extérieurs connectés à des entrées/sorties du circuit intégré 400. En variante, la capacité électrique 120 peut être intégrée au circuit 400.

Les différentes variantes précédemment décrites peuvent s'appliquer au dispositif 100 ainsi réalisé.

Dans tous les exemples et modes de réalisation précédemment décrits, le circuit d'amorçage 104 comporte un transistor bipolaire (le quatrième transistor bipolaire 116 dans le premier mode de réalisation, ou le troisième transistor bipolaire 142 dans le deuxième mode de réalisation) formant un interrupteur permettant de fournir le courant d'amorçage à la gâchette 206 du TRIAC 200. En variante, le circuit d'amorçage 104 peut comporter, à la place du quatrième transistor bipolaire 116 ou du troisième transistor bipolaire 142, un transistor MOS. Dans cette variante, la grille du transistor MOS est connectée comme la base du transistor bipolaire 116 ou 142, et les électrodes de drain et de source sont connectées de manière analogue à l'émetteur et au collecteur du transistor bipolaire 116 ou 142.

En variante des modes de réalisation précédemment décrits, le dispositif 100 peut comporter en outre deux diodes Zener 144, 146 permettant de régler l'instant de conduction des transistors.

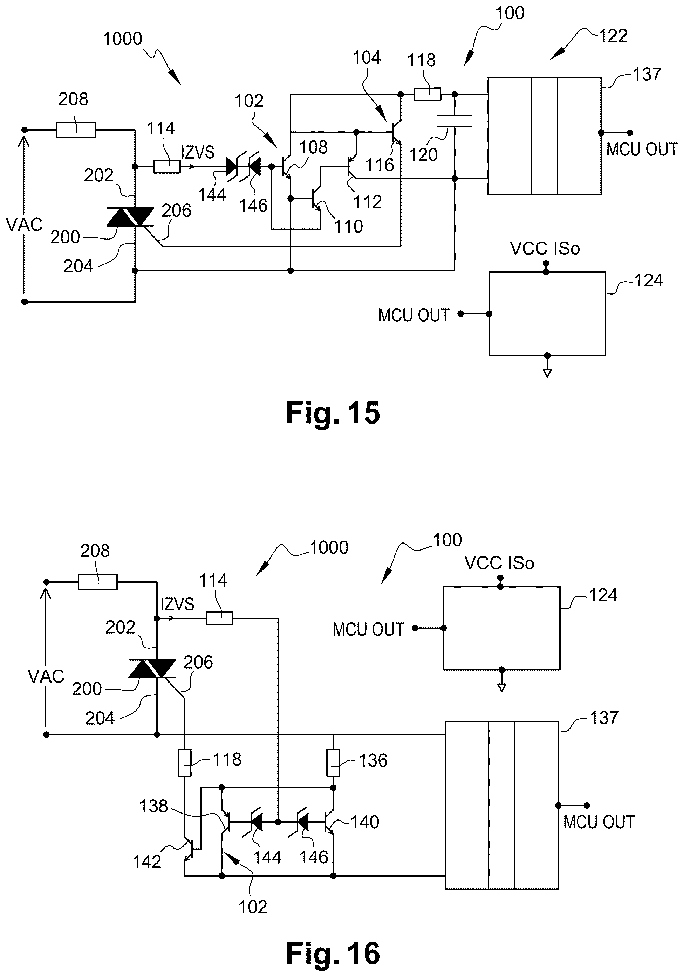

La figure 15 représente le dispositif 100 selon le premier mode de réalisation et comprenant les deux diodes Zener 144, 146 couplées en série l'une à l'autre et telles que leurs cathodes soient couplées l'une à l'autre. L'anode de la diode Zener 144 est couplée à la première résistance 114, et l'anode de la diode Zener 146 est couplée à la base du premier transistor bipolaire 108. Les autres éléments du dispositif 100 sont similaires à ceux précédemment décrits.

La figure 16 représente le dispositif 100 selon le deuxième mode de réalisation et comprenant les deux diodes Zener 144, 146 couplées en série l'une à l'autre et telle que la cathode de la diode Zener 146 soit couplée à l'anode de la diode Zener 144. La cathode de la diode Zener 144 est couplée à la base du premier transistor bipolaire 138, et l'anode de la diode Zener 146 est couplée à la base du deuxième transistor bipolaire 140.

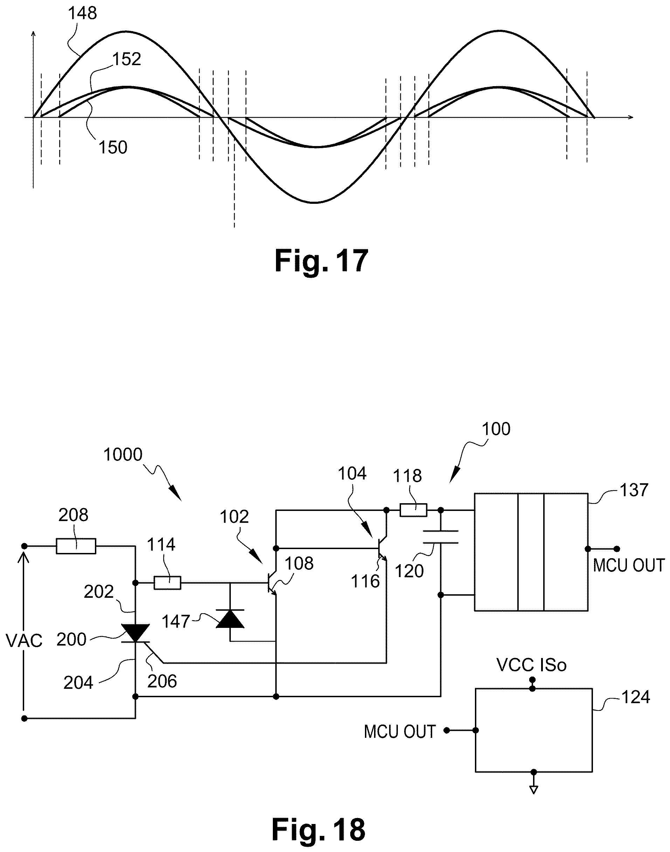

La figure 17 représente, pour une tension VAC désignée par la référence 148, un courant *IZVS,* désigné par la référence 150, obtenu dans le dispositif 100 de la figure 15. A titre de comparaison, la référence 152 désigne le courant *IZVS* obtenu dans le dispositif 100 en l'absence des diodes Zener 144, 146. Ces courbes montrent que la présence des diodes Zener 144, 146 dans le dispositif 100 permet de modifier les instants auxquels les transistors bipolaires couplés à ces diodes Zener passent d'un état, passant ou bloqué, à l'autre.

Ces diodes Zener 144, 146 peuvent également être présentes dans les autres variantes de réalisation du dispositif 100 précédemment décrites.

Selon une autre variante représentée sur la figure 18, le commutateur de puissance 200 correspond à un thyristor. En outre, dans cette variante, le dispositif 100 ne comporte, comme transistors bipolaires, que le premier transistor bipolaire 108 et le quatrième transistor bipolaire 116. Dans cette variante, le dispositif 100 comporte également une diode 147 comprenant sa cathode couplée à la première résistance 114 et à la base du premier transistor bipolaire 108, et son anode couplée à l'émetteur du premier transistor bipolaire 108. Cette variante peut être combinée avec les autres variantes précédemment décrites, pour les différents modes de réalisation décrits.

Dans les différentes configurations, exemples et mode de réalisation, le dispositif 100 permet de commander automatiquement au moins un commutateur de puissance à trois électrodes tel qu'un TRIAC ou un thyristor, et permettant de commander automatiquement l'amorçage ou le blocage du commutateur de puissance lors d'une passage par zéro d'une tension alternative appliquée sur le commutateur de puissance sans que la détection de ce passage par zéro soit détecté par un microcontrôleur.

De plus, le dispositif 100 ne nécessite pas l'ajout d'un circuit extérieur couplé en parallèle du commutateur de puissance pour détecter le passage par zéro de la tension alternative de puissance reçue par le dispositif 100.

En outre, le dispositif 100 n'engendre pas de délai important entre la commande d'amorçage reçue par le dispositif 100 et l'amorçage du commutateur de puissance.

Le dispositif 100 permet également d'avoir les avantages apportés par une commande ZVS du commutateur de puissance tout en engendrant peu de perturbations électromagnétiques.

Selon le mode de réalisation choisi, le dispositif 100 peut réaliser un amorçage du commutateur de puissance dans n'importe lequel des quadrants Q1, Q2, Q3 et Q4.

Dans les différentes configurations, exemples et modes de réalisation décrits, la référence 1000 désigne le système de puissance incluant le commutateur de puissance 200, le circuit de puissance auquel le commutateur 200 est couplé, ainsi que le dispositif de commande 100.

Le dispositif 100 peut être utilisé dans de nombreux domaines faisant appel à de tels systèmes de puissance 1000 tels que celui des véhicules électriques, de l'industrie, des convertisseurs de puissance, des appareils ménagers et électroménagers domestiques, etc.

Le dispositif 100 est par exemple destiné à l'industrie automobile. L'électrification des véhicules automobiles génère un niveau de contenu électronique de plus en plus élevé dans les véhicules. Le dispositif 100 peut être utilisé au sein de systèmes comprenant par exemple des thyristors, des TRIACs, des redresseurs, des diodes de suppression des tensions transitoires à haute tension, des modules, etc. destinés à être incorporés dans lesdits véhicules. L'automatisation de la conduite génère également un contenu électronique de plus en plus important dans les véhicules. De tels systèmes comprennent par exemple des diodes de suppression des tensions transitoires à haute tension, une protection contre les décharges électromagnétiques et des filtres de mode commun pour protéger contre les risques électriques dans l'électronique complexe émergente.

Le dispositif 100 peut par exemple être utilisé dans le domaine industriel. Plus particulièrement, le dispositif 100 peut par exemple être utilisé pour le développement des énergies vertes ou pour l'électrification d'infrastructures, par exemple pour des bornes de recharge ou pour l'incorporation d'énergie solaire. Le dispositif 100 peut également être utilisé dans le domaine de l'internet des objets et des maisons intelligentes. Le dispositif 100 est par exemple destiné à être mis en œuvre dans les circuits de puissance et d'énergie d'équipements, comprenant par exemple des thyristors 800V ou 1200V, des diodes 1200V ultrarapides et au carbure de silicium, des diodes de suppression des tensions transitoires, et des protections contre les décharges électromagnétiques. Le dispositif 100 peut également être utilisé dans la mise en œuvre de nuages, de réseaux 5G, de centres de données et de serveurs.

Le dispositif 100 est par exemple destiné à être utilisé dans des équipements de communication, ou dans des ordinateurs et des périphériques. Par exemple, le dispositif 100 peut être utilisé dans les infrastructures 5G et les centres de données dédiés. Le dispositif 100 peut faire partie d'équipements comprenant par exemple des diodes en carbure de silicium, des transistors Schottky de puissance, des protections contre les décharges électromagnétiques et des diodes de suppression des tensions transitoires. Le dispositif 100 peut également être utilisé dans les satellites, comprenant par exemple des dispositifs passifs intégrés pour les applications de radiofréquence.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

## Revendications

1. Dispositif de commande (100) d'au moins un commutateur de puissance (200) à trois électrodes (202, 204, 206), comprenant au moins :
- un circuit de détection (102) comprenant des transistors bipolaires (108, 110, 112, 138, 140) couplés à une première électrode de puissance (202) du commutateur de puissance (200), et configuré pour extraire un courant de détection dont la valeur est proportionnelle à celle d'une tension entre la première et une deuxième électrodes de puissance (202, 204) du commutateur de puissance (200) lorsque le commutateur de puissance (200) est bloqué ;
- un circuit d'amorçage (104), couplé à une électrode de commande (206) du commutateur de puissance (200) et au circuit de détection (102), et configuré pour délivrer un courant d'amorçage non nul sur l'électrode de commande (206) lorsque le courant de détection est nul et qu'un signal de commande d'amorçage non nul est reçu sur une entrée de commande (106) du circuit d'amorçage (104).

2. Dispositif de commande (100) selon la revendication 1, dans lequel le circuit de détection (102) est configuré pour faire passer le courant de détection depuis l'une vers l'autre des première et deuxième électrodes de puissance (202, 204) du commutateur de puissance (200) lorsque le commutateur de puissance (200) est dans un état bloqué.

3. Dispositif de commande (100) selon l'une quelconque des revendications précédentes, configuré pour commander le commutateur de puissance (200) qui correspond à un TRIAC, l'électrode de commande (206) correspondant à la gâchette du TRIAC et les électrodes de puissance (202, 204) correspondant aux anodes du TRIAC.

4. Dispositif de commande (100) selon l'une quelconque des revendications précédentes, dans lequel les transistors bipolaires du circuit de détection (102) correspondent au moins à :
- un premier transistor bipolaire (108) de type NPN comprenant sa base couplée à la première électrode de puissance (202) du commutateur de puissance (200), son collecteur couplé à l'entrée de commande (106) du circuit d'amorçage (104), et son émetteur couplé à la deuxième électrode de puissance (204) du commutateur de puissance (200) ;
- un deuxième transistor bipolaire (110) de type NPN comprenant sa base couplée à l'émetteur du premier transistor bipolaire (108), et son émetteur couplé à la base du premier transistor bipolaire (108) ;
- un troisième transistor bipolaire (112) de type PNP comprenant sa base couplée au collecteur du deuxième transistor bipolaire (110), son émetteur couplé au collecteur du premier transistor bipolaire (108), et son collecteur couplé à la deuxième électrode de puissance (204) du commutateur de puissance (200).

5. Dispositif de commande (100) selon la revendication 4, dans lequel le circuit d'amorçage (104) comporte un quatrième transistor bipolaire (116) de type NPN comprenant sa base couplée au collecteur du premier transistor bipolaire (108), son collecteur couplé à l'entrée de commande (106) du circuit d'amorçage (104), et son émetteur couplé à l'électrode de commande (206) du commutateur de puissance (200), ou un transistor MOSFET comprenant sa grille couplée au collecteur du premier transistor bipolaire (108), une première électrode de source ou de drain couplée à l'entrée de commande (106) du circuit d'amorçage (104), et une deuxième électrode de source ou de drain couplée à l'électrode de commande (206) du commutateur de puissance (200).

6. Dispositif de commande selon l'une quelconque des revendications 1 à 3, dans lequel les transistors bipolaires du circuit de détection (102) correspondent au moins à :
- un premier transistor bipolaire (138) de type PNP comprenant sa base couplée à une première des deux électrodes de puissance (202) du commutateur de puissance (200), son émetteur couplé à une deuxième des deux électrodes de puissance (204) du commutateur de puissance (200), et son collecteur couplé à l'entrée de commande (206) du circuit d'amorçage (200), et
- un deuxième transistor bipolaire (140) de type NPN comprenant sa base couplée à la base du premier transistor bipolaire (138), son émetteur couplé au collecteur du premier transistor bipolaire (138), et son collecteur couplé à l'émetteur du premier transistor bipolaire (138).

7. Dispositif de commande selon la revendication 6, dans lequel le circuit d'amorçage (104) comporte un troisième transistor bipolaire (142) comprenant sa base couplée à l'émetteur du premier transistor bipolaire (138) et au collecteur du deuxième transistor bipolaire (140), son émetteur couplé au collecteur du premier transistor bipolaire (138), et son collecteur couplé à l'électrode de commande (206) du commutateur de puissance (200), ou un transistor MOSFET comprenant sa grille couplée à l'émetteur du premier transistor bipolaire (138) et au collecteur du deuxième transistor bipolaire (140), une première électrode de source ou de drain couplée au collecteur du premier transistor bipolaire (138), et une deuxième électrode de source ou de drain couplée à l'électrode de commande (206) du commutateur de puissance (200).

8. Dispositif de commande (100) selon l'une quelconque des revendications précédentes, comportant en outre au moins une première résistance électrique (114) de limitation de courant couplée entre la première des deux électrodes de puissance (202) du commutateur de puissance (200) et le circuit de détection (102).

9. Dispositif de commande (100) selon l'une quelconque des revendications précédentes, comportant en outre une capacité électrique (120) couplée entre l'entrée de commande (106) du circuit d'amorçage (104) et la deuxième électrode de puissance (204) du commutateur de puissance (200).

10. Dispositif de commande (100) selon l'une quelconque des revendications précédentes, comportant en outre un circuit de connexion configuré pour connecter ou non le circuit de détection (102) à la première électrode de puissance (202) du commutateur de puissance (200).

11. Dispositif de commande (100) selon l'une quelconque des revendications précédentes, comportant en outre au moins une deuxième résistance électrique (118) de limitation de courant couplée à l'électrode de commande (206) du commutateur de puissance (200).

12. Dispositif de commande (100) selon l'une quelconque des revendications précédentes, comportant en outre un circuit d'attaque (122) doté d'au moins une sortie couplée à l'entrée de commande (106) du circuit d'amorçage (104) et comprenant une isolation galvanique.

13. Dispositif de commande (100) selon la revendication 12, dans lequel le circuit d'attaque (122) comporte un microcontrôleur (124).

14. Dispositif de commande (100) selon l'une quelconque des revendications 12 ou 13, dans lequel le circuit d'attaque (122) est configuré pour envoyer sur sa sortie le signal de commande d'amorçage sous la forme d'impulsions synchronisées avec des passages par une valeur nulle d'une tension aux bornes des électrodes de puissance (202, 204) du commutateur de puissance (200).

15. Système de puissance (1000) comprenant au moins le commutateur de puissance (200) et un dispositif de commande (100) selon l'une quelconque des revendications précédentes et couplé aux deux électrodes de puissance (202, 204) et à l'électrode de commande (206) du commutateur de puissance (200).
